# EUROPEAN PATENT APPLICATION

(11) **EP 1 420 461 A2**
(43) Date of publication of application: **19.05.2004**
(21) Application number: 03025914.7
(22) Date of filing: 12.11.2003
(51) Int. Cl.: H01L 31/075, H01L 31/20, H01L 31/18

(54) **Stacked photovoltaic device**

(30) Priority: 13.11.2002 JP 2002328999
(71) Applicant: CANON KABUSHIKI KAISHA, Ohta-ku Tokyo 146-8501 (JP)
(72) Inventor: Sugiyama, Shuichiro, Ohta-ku, Tokyo (JP); Shiozaki, Atsushi, Ohta-ku, Tokyo (JP); Takai, Yasuyoshi, Ohta-ku, Tokyo (JP); Tsuzuki, Hidetoshi, Ohta-ku, Tokyo (JP)
(74) Representative: Leson, Thomas Johannes Alois, Dipl.-Ing.

(57) **Abstract**

Provided is a stacked photovoltaic device characterized in that: a first i-type semiconductor layer comprises amorphous silicon hydride, and second and subsequent i-type semiconductor layers comprise amorphous silicon hydride or microcrystalline silicon, the i-type semiconductor layers being stacked in order from a light incidence side; and when an open circuit voltage is assigned Voc in the case where a pin photoelectric single element is manufactured using a pin element having the i-type semiconductor layer made of microcrystalline silicon of pin elements having the second and subsequent i-type semiconductor layers, respectively, and a layer thickness of the i-type semiconductor layer concerned is assigned t, a short-circuit photoelectric current density of the stacked photovoltaic device is controlled by the pin element including the i-type semiconductor layer having the largest value of Voc/t.

## Description

### BACKGROUND OF THE INVENTION

### Field of the Invention

The present invention relates to a photovoltaic device such as a solar cell, a sensor or an imaging device, and more particularly to a stacked photovoltaic device having a plurality of pin junctions stacked therein.

### Related Background Art

Heretofore, for the purpose of enhancing an efficiency of an amorphous silicon solar cell and of reducing light degradation, there have been disclosed many techniques concerning a stacked photovoltaic device in which a plurality of pin elements are joined to one another. In one of the techniques, solar light is optically divided into a plurality of wavelength sensitivity regions to be absorbed, to thereby allow carriers generated through reception of the solar light to be more efficiently utilized while also the number of carriers generated through reception of the solar light in each element is reduced. Consequently, light degradation is suppressed.

For example, as for a stacked amorphous silicon solar cell having a three-layer structure, a device having the three-layer structure composed of a-SiC/a-Si/a-SiGe, a-Si/a-SiGe/a-SiGe, a-SiC/a-SiGe/a-SiGe, or the like is proposed (refer to Japanese Patent Application Laid-Open No. H5-102505), and an attempt has been made for efficiently utilizing solar light.

However, in an amorphous material such as a-SiGe, or a-Si, travelling property of carriers is lower than that in microcrystalline silicon or crystalline silicon. In addition, as thickness of the amorphous material is increased, its film characteristics are remarkably deteriorated. Hence, there is a limit to the way of increasing a photoelectric current density by thickening a film. In particular, an a-SiGe-based film has a problem that if its thickness is increased, then the degradation becomes remarkable when light is applied to this film.

On the other hand, in recent years, it was disclosed by Neuchatel University that a high quality microcrystalline silicon thin film can be formed by utilizing the plasma CVD method (refer to U. S. Patent No. 6,309,906), and studies regarding this technique have been conducted in various organs.

Japanese Patent Application Laid-Open No. H11-243218 discloses a stacked photovoltaic device having a three-layer structure composed of a-Si/µC-Si/µC-Si.

In addition, Japanese Patent Application Laid-Open No. H11-243219 discloses a stacked photovoltaic device in which a current value is controlled by a constituent element including a pin junction having a microcrystalline semiconductor material as an i layer to thereby allow a device of a high efficiency to be formed.

However, it was judged that the degradation of the characteristics of microcrystalline silicon due to the application of light is less than that of amorphous silicon, or such degradation of the characteristics is hardly caused. Hence, until now there has not been disclosed at all such a technique as to give a solution to a problem concerning what kind of stacked structure can provide the optimal photovoltaic characteristics in a stacked photovoltaic device in which a plurality of i-type semiconductor layers are formed of microcrystalline silicon.

However, in actuality, in microcrystalline silicon as well, it has been made clear that the film quality and the optical degradation characteristics greatly differ depending on formation conditions and a thickness of microcrystalline silicon. Hence, it is necessary to design a stacked photovoltaic device with due consideration for the optical degradation characteristics of microcrystalline silicon.

### SUMMARY OF THE INVENTION

In the light of the foregoing, the present invention has been made in order to solve the above-mentioned problems associated with the prior art, and it is, therefore, an object of the present invention to provide a silicon-based photovoltaic device which is capable of exhibiting a high photoelectric conversion efficiency and of maintaining stable characteristics for a long period of time against application of light in a stacked photovoltaic device including a plurality of photovoltaic devices each having a pin junction which are stacked, in which a plurality of i-type semiconductor layers comprise microcrystalline silicon.

In order to attain the above object, according to the present invention, there is provided a stacked photovoltaic device including a plurality of photovoltaic devices each having a pin junction including a p-type semiconductor, an i-type semiconductor, and an n-type semiconductor each made of a non-single crystal having an element belonging to the IV group as a main component and which are stacked on a substrate, characterized in that: a first i-type semiconductor layer comprises amorphous silicon hydride, and second and subsequent i-type semiconductor layers comprise amorphous silicon hydride or microcrystalline silicon, the i-type semiconductor layers being stacked in order from a light incidence side; and when an open circuit voltage is assigned Voc in the case where a pin photoelectric single element is manufactured using a pin element having the i-type semiconductor layer made of microcrystalline silicon of pin elements (pin photoelectric element having pin junction) having the second and subsequent i-type semiconductor layers, respectively; and a layer thickness of the i-type semiconductor layer concerned is assigned t, a short-circuit photoelectric current density of the stacked photovoltaic device is controlled by the pin element including the i-type semiconductor layer having the largest value of Voc/t. At this time, it is desirable that when solar light of AM1.5 is applied to the stacked photovoltaic device under the condition of 1SUN and at 25°C, a sum of the short-circuit photoelectric current densities obtained from the individual layers is equal to or larger than 27 mA/cm². Further, it is desirable that in the photovoltaic devices, the short-circuit photoelectric current density of the pin element having the i-type semiconductor layer made of amorphous silicon hydride is larger than that of the pin element having the i-type semiconductor layer made of microcrystalline silicon.

### BRIEF DESCRIPTION OF THE DRAWINGS.

FIG. 1 is a graphical representation showing typical experiment results useful in explaining a relationship among Voc/t, a control element and device characteristics in a stacked photovoltaic device of the present invention;
FIG. 2 is a graphical representation showing typical experiment results useful in explaining a relationship among Voc/t, a control element and device characteristics in a stacked photovoltaic device of the present invention;
FIG. 3 is a graphical representation showing typical experiment results useful in explaining a relationship among Voc/t, a control element and device characteristics in a stacked photovoltaic device of the present invention;
FIG. 4 is a graphical representation showing typical experiment results useful in explaining a relationship among Voc/t, a control element and device characteristics in a stacked photovoltaic device of the present invention;
FIG. 5 is a schematic view showing a deposition film forming system for forming a stacked photovoltaic device of the present invention;
FIG. 6 is a graphical representation showing a relationship between a total photoelectric current density and a photoelectric conversion efficiency after degradation of a stacked photovoltaic device; and
FIG. 7 is a schematic view showing a form of a layer structure of a stacked photovoltaic device of the present invention.

### DETAILED DESCRIPTION OF THE PREFERRED EMBODIMENTS

As described above, the present invention relates to a novel stacked photovoltaic device, and an operation of the present invention will hereinafter be described in detail.

In a stacked photovoltaic device in which a plurality of photovoltaic devices each having a pin junction are joined in series with one another (for example, the constituent elements of a triple device are called a top element, a middle element, and a bottom element from a light incidence side), a short-circuit photoelectric current density of the stacked photovoltaic device can be maximized by making densities of short-circuit photoelectric currents generated in the respective constituent elements equal to one another. However, the characteristics of the whole device has a tendency to strongly reflect the characteristics of the constituent element (control element) having the least photoelectric current generated therein. Hence, an appropriate current balance is obtained rather than densities of short-circuit photoelectric currents generated in the respective constituent elements are made equal to one another, whereby the photoelectric conversion efficiency of the whole device can be enhanced. Consequently, even if film qualities of the constituent elements are equal to one another, how a control element is selected exerts a large influence on the photoelectric conversion efficiency of the device.

As described in Japanese Patent Application Laid-Open No. H11-243219, since the characteristics of the amorphous silicon photovoltaic device are greatly degraded by application of light, it is not preferable to set a top element as a control element since the characteristics are further reduced after light degradation. On the other hand, it has been made clearer that the characteristics of a film made of microcrystalline silicon largely differ depending on the manufacture conditions. It is conceived that this is because unlike a crystal, grain boundaries are present in a microcrystal, and hence a state of grain boundaries, a crystal grain diameter, a microcrystallization rate and the like are changed depending on the manufacture conditions. For this reason, in particular, Voc when a pin photovoltaic single device is manufactured can be largely changed so as to fall within the range of about 0.3 to about 0.6 V. In this case, while its light degradation rate due to application of light is small as compared with an amorphous silicon film, its light degradation rate is changed largely depending on a film quality of a microcrystalline i-type semiconductor layer.

The present inventors have earnestly made a study of this respect, and as a result, they have found out that in a stacked photovoltaic device in which a plurality of i-type semiconductor layers comprise microcrystalline silicon, when a layer thickness of the microcrystalline i-type semiconductor layer is assigned t, a pin element having the largest Voc/t is selected as a control element, whereby the characteristics after light degradation can be greatly enhanced. Voc/t is a parameter correlating with an internal electric field. It is conceivable that the travelling property of carriers are further enhanced as Voc/t is increased, and as a result, the characteristics of the whole device can be enhanced, and also a rate of degradation due to application of light for a long period of time can be reduced.

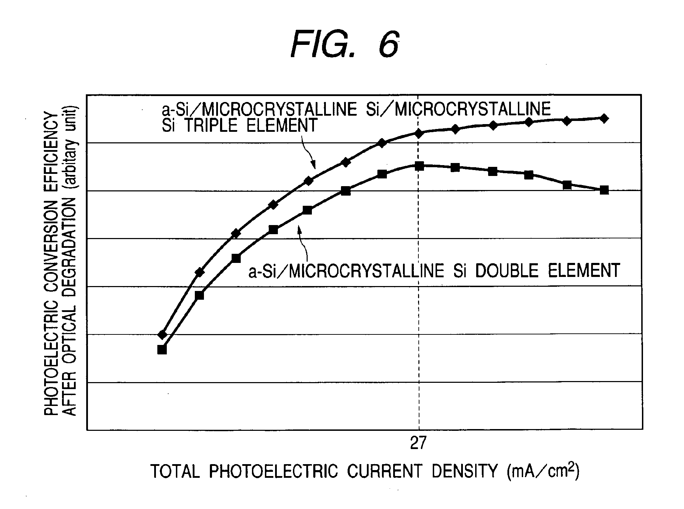

Moreover, the stacked photovoltaic device of the present invention especially shows a large effect in a case where a sum of densities of photoelectric currents obtained from individual pin elements when the solar light of AM1.5 is applied to the stacked photovoltaic device under the conditions of 1SUN, 25°C is equal to or larger than 27 mA/cm². FIG. 6 shows a graphical representation in which for a triple element composed of a-Si/microcrystalline Si/microcrystalline Si, and a double element composed of a-Si/microcrystalline Si, data of photoelectric conversion efficiency after light degradation is plotted against a sum of current densities obtained from the respective elements (total photoelectric current density). As shown in FIG. 6, it is understood that while when the current density is smaller than 27 mA/cm², the photoelectric conversion efficiency of the triple element is slightly larger than that of the double element, when the current density becomes larger than 27 mA/cm², as the total photoelectric current density is increased, the photoelectric conversion efficiency of the triple element becomes greatly larger than that of the double element. As this cause, it is mainly presumable that since a short-circuit photoelectric current density (Jsc) of the double element is about 1.5 times as large as that of the triple element if their film qualities are equal to each other, the light degradation of the a-Si layer becomes abruptly remarkable as the total photoelectric current density is increased. From a viewpoint of a manufacture cost as well, the raw material cost and the manufacture time of the triple element are increased as compared with the double element. Thus, it is judged that the cost per output electric power of the triple element becomes more advantageous than that of the double element when the total photoelectric current density is nearly equal to or larger than 27 mA/cm².

In such a manner, the present inventors have found out that the photoelectric conversion efficiency of the stacked photovoltaic device manufactured by stacking three or more layers of the photovoltaic elements each having a pin junction is most remarkably enhanced when the total photoelectric current density is equal to or larger than 27 mA/cm².

In addition, the pin element having an i-type semiconductor layer made of amorphous silicon is more remarkable in the characteristics degradation due to application of light than the pin element having an i-type semiconductor layer made of microcrystalline silicon. Thus, the short-circuit photoelectric current density of the pin element having an i-type semiconductor layer made of amorphous silicon is made larger than that of the pin element having an i-type semiconductor layer made of microcrystalline silicon to thereby allow the device characteristics after light degradation to be enhanced.

Embodiments of the stacked photovoltaic device of the present invention will hereinafter be described in detail with reference to the accompanying drawings. It should be noted that the present invention is not intended to be limited to these embodiments.

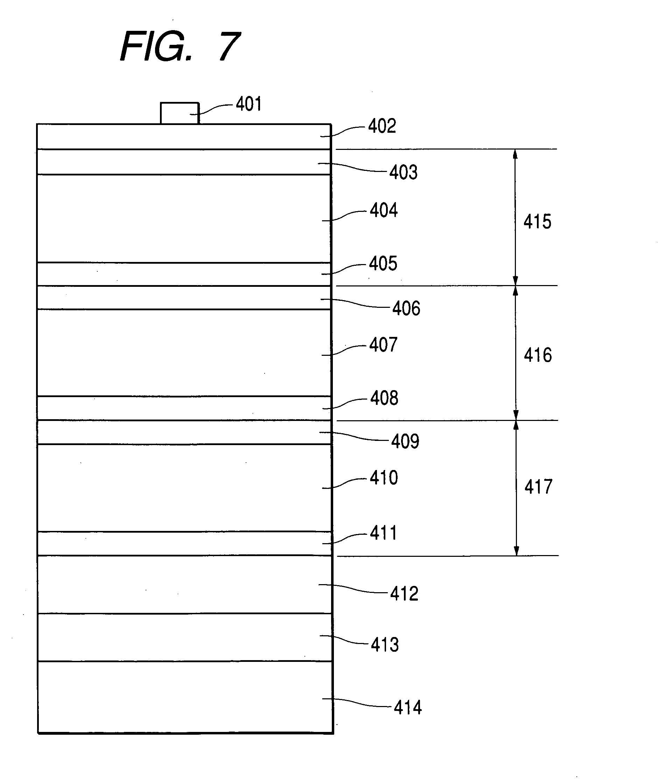

FIG. 7 is a schematic view showing a form of a layer structure of a stacked photovoltaic device of the present invention. The stacked photovoltaic device shown in FIG. 7 has a layer structure in which a collector electrode 401 made of metal such as Ag, a transparent and electroconductive antireflection layer 402 made of indium oxide, tin oxide, or the like, a first p(n)-type semiconductor layer 403, a first i-type semiconductor layer 404, a first n(p)-type semiconductor layer 405, a second p(n)-type semiconductor layer 406, a second i-type semiconductor layer 407, a second n(p)-type semiconductor layer 408, a third p(n)-type semiconductor layer 409, a third i-type semiconductor layer 410, a third n(p)-type semiconductor layer 411, a reflection enhancing layer 412 made of zinc oxide, indium oxide, tin oxide, or the like, and a reflecting layer 413 made of Al, Cu, Ag, etc. are formed in this order from a light incidence side on a substrate 414 such as a metallic substrate made of stainless steel, or an insulating substrate made of glass. In addition, the elements each composed of a pin structure are called a top element 415, a middle element 416, and a bottom element 417, respectively, from the light incidence side.

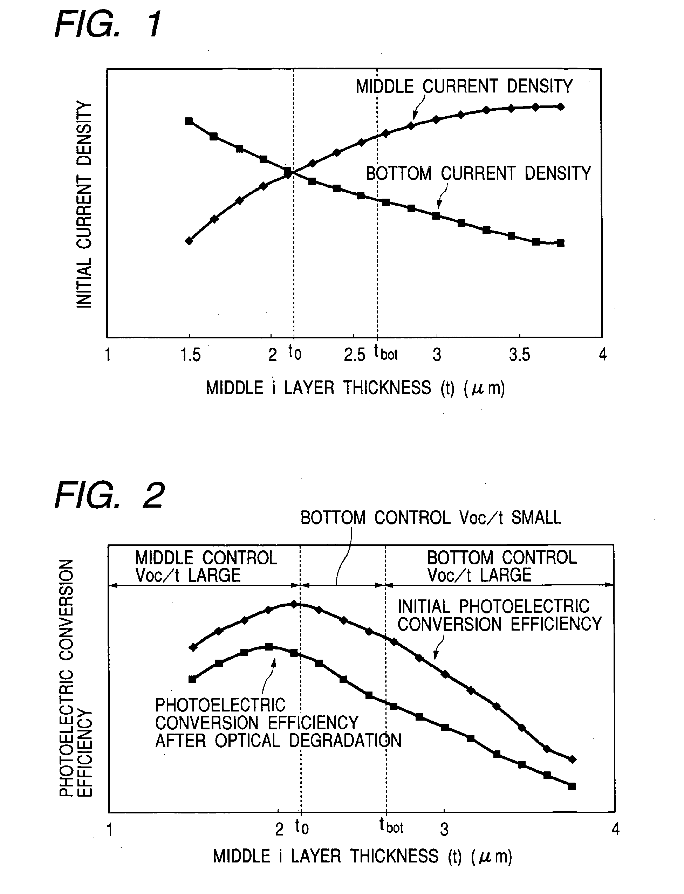

FIG. 1 is a graphical representation showing a change in short-circuit photoelectric current densities of the middle element and the bottom element when the triple element having an i layer of the top element made of amorphous silicon hydride, and i layers of the middle element and the bottom element made of microcrystalline silicon is manufactured while changing a thickness (assigned t) of the i-type semiconductor layer of the middle element. At this time, the manufacture conditions of the top element and the bottom element are made fixed, and the condition is selected such that when each of the bottom element and the middle element is manufactured in the form of a single element, the same Voc is obtained. In FIG. 1, t_{bot} represents a layer thickness of the i-type semiconductor layer of the bottom element, and t₀ represents a layer thickness of the i-type semiconductor layer of the middle element at which the short-circuit photoelectric current densities of the bottom element and the middle element become equal to each other. As a result, for layer thickness areas of the i layer of the middle element, a relationship between the control element and Voc/t is expressed as shown in Table 1.

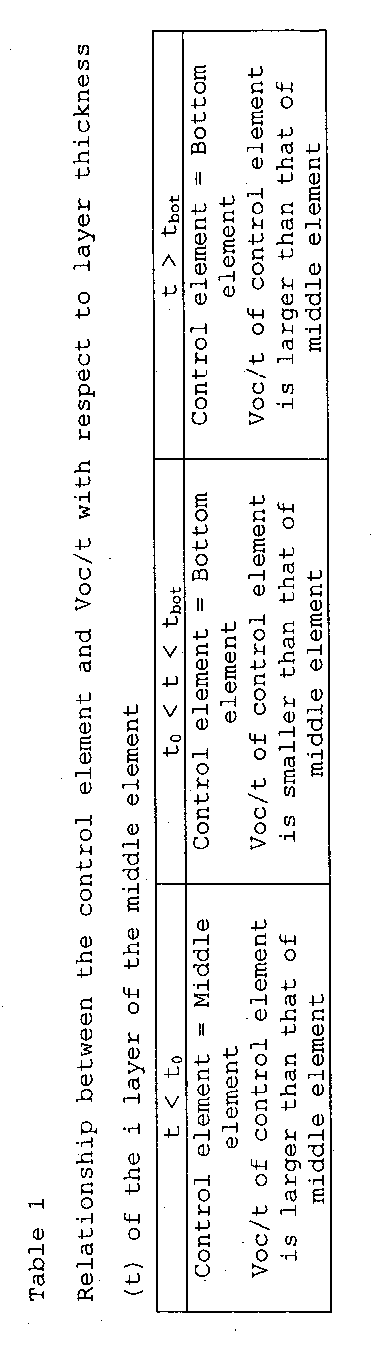

FIG. 2 is a graphical representation showing a relationship between an initial photoelectric conversion efficiency, and a photoelectric conversion efficiency after degradation since the photovoltaic device is optically degraded due to light application at 1SUN, 50°C for 1,000 hours the data of which is plotted against a thickness (t) of the i layer of the middle element. From FIG. 2, it is understood that in an area of t < t₀ and an area of t₀ < t < t_{bot}, a device fulfilling the area of t < t₀ of devices having nearly the same initial photoelectric conversion efficiency shows a higher photoelectric conversion efficiency after degradation. Moreover, it is understood that in a triple element having the maximum photoelectric conversion efficiency after degradation, in case of the area of t < t₀, a middle element having a larger value of Voc/t becomes a control element. That is to say, it is shown that the adjustment is made so that an element having a larger value of Voc/t becomes a control element, whereby the photoelectric conversion efficiency after degradation is enhanced. Note that, though in an area of t > t_{bot}, the light degradation is not remarkable, since the initial photoelectric conversion efficiency is extremely reduced, no high efficiency is expected.

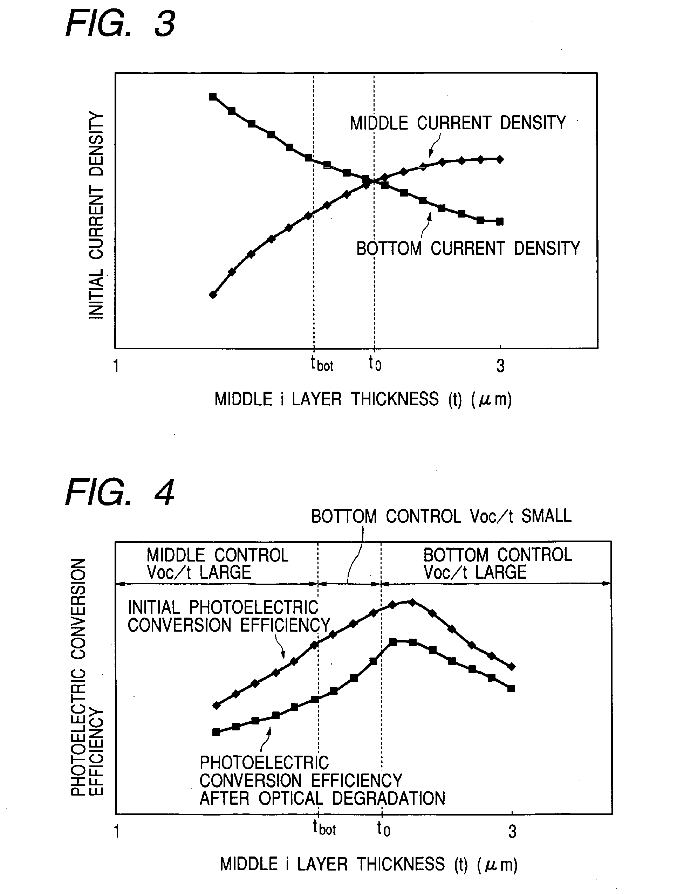

Likewise, in FIG. 3, short-circuit photoelectric current densities of a bottom element and a middle element when t_{bot} is smaller than t₀ are shown as a function of a thickness (t) of an i layer of the middle element. Hence, for setting t_{bot} to be smaller than t₀, various methods are available. For example, when a reflection enhancing film having a high texture degree, since a current of a bottom element can be mainly increased by reflected light from a rear face, it is possible to decrease a layer thickness of an i layer of the bottom element. In other words, since incident light is absorbed from the i-type semiconductor layer on a light incidence side, a quantity of incident light is successively decreased after passing through the top element, the middle element, and the bottom element in this order. However, in the bottom element, an increase in quantity of current due to the reflected light is anticipated. For this reason, a magnitude relationship between the photoelectric current densities of the middle element and the bottom element is changed depending on not only layer thicknesses and film qualities of the i layer of the middle element and the i layer of the bottom element, but also a reflectivity and a reflection angle of the reflection enhancing film. These parameters are controlled to allow magnitudes of Voc/t of the elements to be changed.

From FIG. 3, for the areas of layer thickness the of the i layer of the middle element, a relationship between the control element and Voc/t is expressed as shown in Table 2.

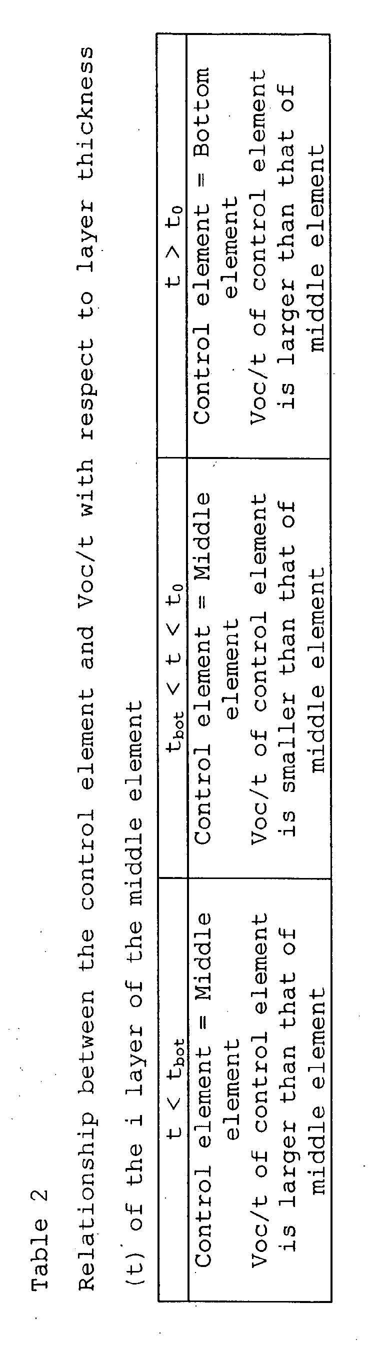

FIG. 4 is a graphical representation showing a relationship between an initial photoelectric conversion efficiency, and a photoelectric conversion efficiency after degradation since the photovoltaic device is optically degraded due to light application at 1SUN, 50°C for 1,000 hours the data of which is plotted against a thickness (t) of the i layer of the middle element. From FIG. 4, it is understood that in an area of t_{bot} < t < t₀ and an area of t > t₀, a device fulfilling the area of t > t₀ of devices having nearly the same initial photoelectric conversion efficiency shows a higher photoelectric conversion efficiency after degradation. Moreover, it is understood that in a triple element having the maximum photoelectric conversion efficiency after degradation, in case of the area of t > t₀, a bottom element having a larger value of Voc/t becomes a control element. In this case as well, it is shown that by setting an element having a larger value of Voc/t as a control element, the photoelectric conversion efficiency after degradation is enhanced. Note that, though in an area of t < t_{bot}, the light degradation is not remarkable, since the initial photoelectric conversion efficiency is extremely reduced, no high efficiency is expected.

The above-mentioned experiments were made with respect to a case where Voc of the middle element is equal to that of the bottom element. However, it has been found out that in a case as well where Voc of the middle element is different from that of the bottom element, likewise, the adjustment is made so that the element having the larger value of Voc/t becomes the control element, whereby it is possible to maximize the photoelectric conversion efficiency after degradation.

Thus, it has become clear that for enhancing the efficiency of the stacked photovoltaic device having a plurality of i-type semiconductor layers each made of microcrystalline silicon, it is important that before the light degradation, in a state in which the short-circuit photoelectric current densities of the constituent elements are close to one another, the pin element including a i-type semiconductor layer made of microcrystalline silicon and having the largest value of Voc/t is set as the control element. Such a relationship is also applied to a stacked photovoltaic device in which four or more layers of photovoltaic devices each having a pin junction are stacked.

Next, a measurement method and a manufacturing system which are applied to the present invention will hereinafter be described in detail.

### (Measurement of Short-Circuit Photoelectric Current)

The short-circuit photoelectric current densities of the constituent elements of the stacked photovoltaic device are measured on the basis of the spectral sensitivity characteristics of elements. For example, in case of a three-layer stacked photovoltaic device in which three photovoltaic devices each having a pin junction are stacked in series with one another, the short-circuit photoelectric currents of a top element, a middle element, and a bottom element, for example, are measured in accordance with the following manner.

The measurement of the short-circuit photoelectric current density of the top element is carried out as follows. A forward bias voltage is applied which corresponds to a sum of electrovoltaic voltages which are generated in the middle element and the bottom element, respectively, when light is applied to the stacked photovoltaic device, and light in the regions in which the light is mainly absorbed by the middle element and the bottom element is applied in the form of bias light. Then, light spectrally separated in this state is applied to measure the spectral characteristics, and the resultant spectral characteristics are multiplied by the spectral intensity of solar light to calculate the short-circuit photoelectric current density of the top element.

For the measurement of the short-circuit photoelectric current density of the middle element, similarly to the case of the top element, a forward bias voltage is applied corresponding to a sum of electrovoltaic voltages generated in the top element and the bottom element, respectively, and light in the regions which the light is mainly absorbed in the top element and the bottom element, respectively, is applied in the form of bias light. Then, light spectrally separated in this state is applied to measure the spectral characteristics, and the resultant spectral characteristics are then multiplied by the spectral intensity of solar light to calculate the short-circuit photoelectric current density of the middle element.

For the measurement of the short-circuit photoelectric current density of the bottom element, likewise, a forward bias voltage is applied corresponding to a sum of electrovoltaic voltages generated in the top element and the middle element, respectively, and light in the regions in which the light is mainly absorbed in the top element and the middle element, respectively, is applied in the form of bias light. Then, light spectrally separated in this state is applied to measure the spectral characteristics, and the resultant spectral characteristics are then multiplied by the spectral intensity of solar light to calculate the short-circuit photoelectric current density of the bottom element.

### (With Respect to Voc in the Present Invention)

Essentially, it is preferable that Voc of each of the single elements is calculated with respect to each of the manufactured single elements. However, in the present invention, for example, the following evaluation method can be substituted for the evaluation for Voc of each of the single elements in the stacked photovoltaic device.

For example, Voc of a bottom element in a triple element is defined as follows. In the above-mentioned method that includes measuring the short-circuit photoelectric current densities, a wavelength of the spectrally separated light is fixed to a wavelength at which the highest quantum efficiency is obtained in a bottom element, and an applied bias voltage is then increased from 0V. Then, the forward bias voltage value when the quantum efficiency is reduced by 1.5% from the case of the applied bias voltage of 0 V is measured. A voltage which is obtained by subtracting the resultant forward bias voltage from Voc which is obtained by applying light of 1SUN and AM1.5 is defined as Voc of the bottom element.

Likewise, in a top element as well, in the above-mentioned method including measuring the short-circuit photoelectric current density, a wavelength of the spectrally separated light is fixed to a wavelength at which the highest quantum efficiency is obtained in the top element, and an applied bias voltage is then increased from 0V. Then, the forward bias voltage value when the quantum efficiency is reduced by 1.5% from the case of the applied bias voltage of 0 V is measured. A value which is obtained by subtracting the resultant forward bias voltage value from Voc of the triple element is defined as Voc of the top element.

Voc of a middle element is similarly defined. However, in case of an element sandwiched between upper and lower elements as in the middle element, a wavelength of the spectrally separated light is fixed to a wavelength at which the highest quantum efficiency is obtained in the middle element, and an applied bias voltage is then increased from 0 V. Then, a forward bias voltage when the quantum efficiency is reduced by 10.0% from the case of the applied bias voltage of 0 V is measured. A voltage which is obtained by subtracting the resultant forward bias voltage from Voc of the triple element is defined as Voc of the middle element. As this reason, it is thought that in case of the middle element, since the bias light is applied so that the excessive carriers are generated in both the top element and the bottom element during the measurement, such a deviation of a threshold occurs due to the excessive carriers generated in the upper element and the lower element sandwiching therebetween the middle element.

### (Definition of Layer Thickness)

Next, a method including measuring a layer thickness will hereinbelow be described. For the measurement of a layer thickness, there is a method including directly observing a layer thickness with a cross section SEM (or TEM), or a method including using a stepped portion measurement instrument. In addition, in some cases, a layer thickness may be calculated on the basis of a product of a film formation rate and a period of time of film formation which are previously measured. However, in case of a photovoltaic device formed by stacking semiconductor layers having different conductivity types on a substrate, there is a possibility that the diffusion of doping elements or the like may occur between the adjacent layers depending on the conditions of formation of the layers. For example, in a case where an i-type semiconductor layer is formed on an n-type semiconductor layer, if doping elements in the n-type semiconductor layer are diffused into the i-type semiconductor layer, then a depletion layer in the i-type semiconductor layer is narrowed. As a result, an effective layer thickness of the i-type semiconductor layer is decreased, and hence this effective layer thickness may be largely different from a layer thickness measured by utilizing the above-mentioned layer thickness measurement method.

Then, for the evaluation of a layer thickness in the present invention, it is preferable to synthetically judge a layer thickness using the above-mentioned measurement method together with a capacitance measurement method. The capacitance measurement method is a method in which a pin type photovoltaic device is regarded as one capacitor to measure a layer thickness of an i layer. A voltage is applied to a sample using a frequency of about 10 kHz to about 10 MHz to measure an electrostatic capacity of the sample, and then a layer thickness is calculated on the basis of a dielectric constant of the i layer. As for an applied voltage at this time, a reverse bias voltage is continuously applied to the sample until the carriers trapped in the i layer are swept out to sufficiently spread the depletion layer so that a capacity shows a fixed value.

In the usual way, a layer thickness measured by utilizing the capacitance measurement method nearly agrees with a layer thickness measured by utilizing the above-mentioned direct measurement method. However, it is conceivable that if for example, doping elements present in a p-type or n layer migrate into an i layer beyond some extent, or the doping elements are intentionally introduced into the i layer, then a depletion layer may be narrowed in some cases. As a result, a layer thickness measured by utilizing the capacitance measurement method may occasionally appear to be thinner. For this reason, while the divergence from the above-mentioned direct measurement method occurs, in the present invention, in this case, a layer thickness measured by utilizing the capacitance measurement method is regarded as a layer thickness of an i layer because it is judged that in the present invention, a parameter of Voc/t is correlated with an initial electric field, and hence an electrical layer thickness has an important meaning.

Here, in the capacitance measurement method, a three-layer stacked device can be regarded as the series-connected three capacitors in terms of an equivalent circuit. Thus, a sum of layer thicknesses of the i layers is obtained on the basis of calculation. In a case where for example, doping elements are diffused only into the i layer of the bottom element to narrow a depletion layer, a difference between a sum of layer thicknesses measured from the observation using a cross section SEM (or a TEM) or layer thicknesses calculated on the basis of a film formation rate and a period of time of film formation previously measured, and a layer thickness measured by utilizing the capacitance measurement method is regarded as a decrease in layer thickness of the i layer of the bottom element due to the narrowing of the depletion layer to calculate a layer thickness of the i layer of the bottom element.

In addition, since the degree of diffusion of the doping elements differs depending on a material or a surface property (texture degree or the like) of a base layer, it is important to carry out the capacity measurement in a state in which layers are stacked in the form of a device.

In addition, as one of methods including checking up the concentration distribution of doping elements in a layer thickness direction, it is possible to use a Secondary Ion Mass Spectroscopy (SIMS). When the concentration of phosphorus (P) phosphorus as the doping element of an n-type semiconductor layer into an i-type semiconductor layer was actually measured, in case of a stacked photovoltaic device for which a layer thickness obtained with the direct layer thickness measurement method and a layer thickness obtained with the capacitance measurement method showed substantially the same value, only a layer thickness of about 80 nm was required for the concentration of P in the layer to decrease from 10¹⁹/cm³ to 10¹⁷/cm³ at an interface between an n layer and an i layer. On the other hand, in a case where a layer thickness obtained with the capacitance measurement method was smaller than that obtained with the direct measurement method by about several hundreds nm, a layer thickness of about 100 to about 200 nm was required for the concentration of P to decrease by same rate. Thus, it has been actually confirmed on the basis of our experiments that there is a correlation between the diffusion of P and a decrease in layer thickness measured with the capacitance measurement method.

### (Deposition film forming system and Method of Forming Stacked photovoltaic device)

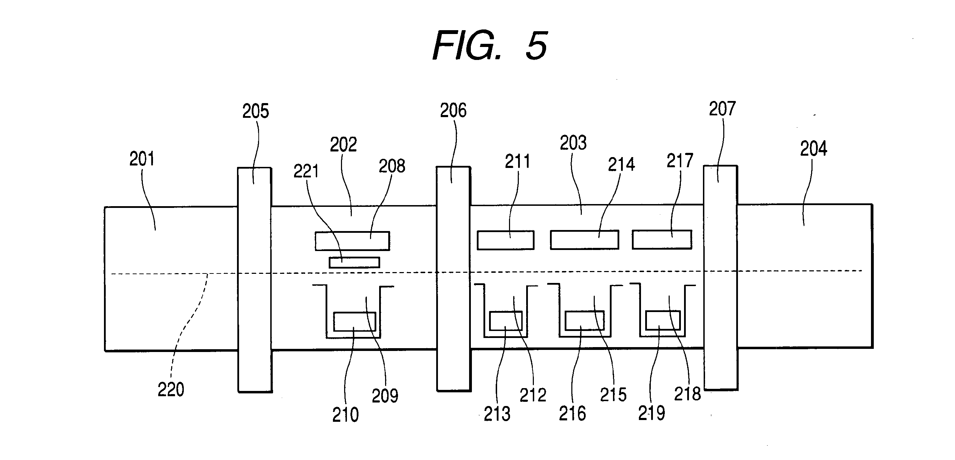

FIG. 5 is a schematic view showing a deposition film forming system for forming the stacked photovoltaic device of the present invention. In FIG. 5, the deposition film forming system is mainly composed of a load chamber 201, a chamber 202 for deposition of a microcrystalline silicon i layer, an RF chamber 203 for deposition of an amorphous silicon i layer, a p layer, and an n layer, and an unload chamber 204. These chambers are separated from one another by gate valves 205, 206, and 207 so as for raw material gases not to be mixed with one another.

The chamber 202 for deposition of a microcrystalline silicon i layer is composed of a heater 208 for heating a substrate, a plasma CVD chamber 209, and a cathode 210 for supplying a VHF electric power.

The RF chamber 203 has a heater 211 for deposition of an n layer and a deposition chamber 212 for deposition of the n layer, a cathode 213 for supplying an RF electric power to the n layer, a heater 214 for deposition of an i layer and a deposition chamber 215 for depositing the i layer, a cathode 216 for supplying an RF electric power to the i layer, a heater 217 for deposition of a p layer and a deposition chamber 218 for depositing the p layer, and a cathode 219 for supplying an RF electric power to the player.

A substrate is mounted to a substrate holder 221 to be moved on a rail 220 by a roller which is driven from the outside.

In the plasma CVD chamber 209, a microcrystalline layer is deposited. For the deposition of the microcrystalline layer, a microwave plasma CVD method or a VHF plasma CVD method is utilized.

The stacked photovoltaic device of the present invention is formed using such a deposition film forming system as follows. First of all, a stainless substrate is set onto the substrate holder 221, and the substrate holder 221 is then set on the rail 220 in the load chamber 201. Then, the air is exhausted from the load chamber 201 to a degree of vacuum of equal to or lower than several hundreds mPa.

Next, the gate valves 205 and 206 are opened to move the substrate holder 221 to the n layer deposition chamber 212 of the chamber 203. Then, the gate valves 205 and 206 are closed to supply a desired raw material gas, and an RF electric power is then supplied from the cathode 213 to decompose the raw material gas to thereby deposit an n layer to a desired thickness. Next, after the gas is sufficiently exhausted, the gate valve 206 is opened to move the substrate holder 221 to the deposition chamber 202, and the gate valve 206 is then closed.

The substrate is heated to a desired substrate temperature by the heater 208, and a necessary quantity of desired raw material gas is introduced into the chamber 209 to effect a desired degree of vacuum. Then, a predetermined VHF energy (or a microwave energy) is introduced into the deposition chamber 209 from the cathode 210 to generate the plasma to thereby deposit an i layer of a bottom element made of microcrystalline silicon on the n layer deposited on the substrate to a desired thickness. After gas is sufficiently exhausted from the chamber 202, the gate valve 206 is opened to move the substrate holder 221 from the chamber 202 to the chamber 203.

The substrate holder 221 is moved to the chamber 218 for deposition of a p layer in the chamber 203 to be heated to a desired temperature by the heater 217. The raw material gas with which a p layer is to be deposited is supplied to the deposition chamber 218 at a desired flow rate, and an RF energy is introduced from the cathode 219 into the deposition chamber 218 while maintaining a desired degree of vacuum to deposit a p layer on the i layer to a desired thickness.

After the deposition of the p layer, the gas is sufficiently exhausted from the deposition chamber 218 to move the substrate holder 221 to the chamber 212 for deposition of an n layer within the same chamber 203. Similarly to the case of the n layer, an n layer is deposited on the p layer. After that, the gas is sufficiently exhausted from the deposition chamber 212 to move the substrate holder 221 again to the chamber 202 for deposition of an i layer.

Similarly to the above, the substrate is heated to a desired substrate temperature by the heater 208 to introduce a necessary quantity of desired raw material gas into the chamber 209 to a desired degree of vacuum. Then, a predetermined microwave energy or VHF energy is introduced into the deposition chamber 209 to generate the plasma to thereby deposit an i layer of a middle element made of microcrystalline silicon on the substrate to a desired thickness. After gas is sufficiently exhausted from the chamber 202, the gate valve 206 is opened to move the substrate holder 221 from the chamber 202 to the chamber 203.

The substrate holder 221 is moved to the chamber 218 for deposition of a p layer in the chamber 203 to be heated to a desired temperature by the heater 217. The raw material gas with which a p layer is to be deposited is supplied to the deposition chamber 218 at a desired flow rate, and the RF energy is introduced into the deposition chamber 218 while maintaining a desired degree of vacuum to deposit a p layer on the i layer to a desired thickness.

After the deposition of the p layer, the gas is sufficiently exhausted from the deposition chamber 218 to move the substrate holder 221 to the chamber 212 for deposition of an n layer within the same chamber 203. Similarly to the case of the n layer, an n layer is deposited on the p layer. Then, the gas is sufficiently exhausted from the deposition chamber 212 to move the substrate holder 221 to the chamber 215 for deposition of an i layer. The substrate is heated to a desired substrate temperature by the heater 214 to introduce the raw material gas with which an i layer is to be deposited into the deposition chamber 215 at a desired flow rate, and a desired RF energy is then introduced from the cathode 216 into the chamber 215 while maintaining a pressure within the deposition chamber 215 at a desired pressure. Then, the gas is sufficiently exhausted from the deposition chamber 215 to move the substrate holder 221 from the deposition chamber 215 to the deposition chamber 218, and similarly to the case of deposition of the above-mentioned p layer, a p layer is then deposited on the i layer. Similarly to the foregoing, after the gas is sufficiently exhausted from the deposition chamber 218, the gate valve 207 is opened to move the substrate holder 221 onto which the substrate having the semiconductor layers deposited thereon is set to the unload chamber 204.

After all the gate valves are closed, a nitrogen gas is enclosed in the unload chamber 204 to cool the substrate to a desired temperature. Thereafter, a takeoff valve of the unload chamber 204 is opened to deliver the substrate holder 221 from the unload chamber 204.

Then, a transparent electrode is deposited onto the p layer to a desired thickness using a vacuum evaporation system (not shown) for depositing a layer of a transparent electrode. Likewise, a layer of a collector electrode is deposited on the transparent electrode.

Next, the constituent elements of the stacked photovoltaic device of the present invention will hereinbelow be described in detail.

### <Substrate and Reflecting Layer>

As a material for a metallic substrate, stainless steel or the like, in particular, ferrite series stainless steel is suitable for the substrate for use in the stacked photovoltaic device of the present invention. In addition, glass, ceramics or the like is suitable for an insulating substrate.

In case of an insulating substrate, it is necessary to deposit a metallic layer or a transparent electroconductive film on the insulating substrate in order to subject a surface of the insulating substrate to conduction processing. When a light-transmissive substrate that comprises glass or the like is used, and a transparent electroconductive film is deposited on the substrate to form a photovoltaic device, not only light can be made incident to a semiconductor side, but also light can be made incident to a transparent substrate side.

As the conduction processing, one is exemplified given to deposit a metallic material such as Al, Ag, or Cu, or an alloy of these metallic materials in the form of a reflecting layer. With respect to a thickness of the reflecting layer, it is necessary to deposit a metallic material to a thickness equal to or larger than that with which a reflectivity of metal itself is obtained.

In order to form the reflecting layer so that its surface becomes flat as much as possible, the reflecting layer is preferably formed at a relatively low temperature to a thickness of several hundreds to 3,000 Å. In addition, in order to form the reflecting layer so that its surface has irregularities, the reflecting layer is preferably formed to a thickness larger than 3,000 Å, but equal to or smaller than several µm.

In addition, the present invention is suitably applied to a roll-to-roll method in which a strip-like substrate made of metal or a resin is used, and the film formation is carried out while conveying the strip-like substrate in a longitudinal direction.

### <Reflection Enhancing Layer>

In addition, it is desirable to provide a reflection enhancing layer adapted to increase a quantity of light absorbed in the semiconductor layers on the above-mentioned metallic substrate or reflecting layer. Oxide such as indium oxide, tin oxide, or zinc oxide is suitable for a material of the reflection enhancing layer. As for a thickness of the reflection enhancing layer, a range of 1,000 to 50,000 Å is given as an optimal range.

### <P Layer and N Layer>

The p layer or the n layer is an important layer controlling the characteristics of the photovoltaic device. As for an amorphous material, a microcrystalline, or a polycrystalline material for the p layer or the n layer, for example, there is given a material which is obtained by adding a highly concentrated p-type valence electron control agent (an atom belonging to the III group in the periodic table: B, Al, Ga, In, or Tl) or a highly concentrated n-type valence electron control agent (an atom belonging to the V group in the periodic table: P, As, Sb, or Bi) to a-Si:H, a-Si:HX, a-SiC:H, a-SiC:HX, a-SiGe:H, a-SiGeC:H, a-SiO:H, a-SiN:H, a-SiON:HX, a-SiOCN:HX, µc-Si:H, µc-SiC:H, µc-Si:HX, µc-SiC:HX, µc-SiGe:H, µc-SiO:H, µc-SiGeC:H, µc-SiN:H, µc-SiON:HX, µc-SiOCN:HX, poly-Si:H, poly-Si:HX, poly-SiC:H, poly-SiC:HX, poly-SiGe:H, poly-Si, poly-SiC, poly-SiGe, or the like.

In particular, a crystalline semiconductor layer having less light absorption, or an amorphous semiconductor layer having a wide band gap is suitable for the p layer or the n layer on the light incidence side.

As for a quantity of addition of an atom belonging to the III group in the periodic table to the p layer, and a quantity of addition of an atom belonging to the V group in the periodic table to the n layer, the range of 0.1 to 50 at% is given as the optimal quantity.

In addition, hydrogen atoms (H, D) or halogen atoms contained in the p layer or the n layer serve to compensate for un-bonded hands of the p layer or the n layer to enhance the efficiency of doping to the p layer or the n layer. As for a quantity of hydrogen atoms or halogen atoms added to the p layer or the n layer, the range of 0.1 to 40 at% is given as the optimal quantity. In particular, in a case where the p layer or the n layer is crystalline, as for a quantity of hydrogen atoms or halogen atoms added to the p layer or the n layer, the range of 0.1 to 8 at% is given as an optimal quantity.

Moreover, a distribution form in which many hydrogen atoms and/or many halogen atoms are distributed on the sides of an interface between the p layer and the i layer, and an interface between the n layer and the i layer is given as a preferred distribution form. Also, a content of hydrogen atoms and/or halogen atoms in the vicinity of each of these interfaces is preferably 1.1 to 2 times as large as that of a bulk. The content of hydrogen atoms or halogen atoms in the vicinity of each of the interface between the p layer and the i layer, and the interface between the n layer and the i layer is increased in such a manner as to allow the number of defective levels or mechanical distortions in the vicinity of each of the interfaces to be decreased. This makes it possible to increase the photovoltaic voltage and the photoelectric current of the stacked photovoltaic device of the present invention.

As for the electrical characteristics of the p layer and the n layer of the photovoltaic device, an activation energy of equal to or lower than 0.2 eV is preferable, and the activation energy of equal to or lower than 0.1 eV is optimal. In addition, a resistivity is preferably equal to or smaller than 100 Ωcm, and most preferably equal to or smaller than 1 Ωcm. Moreover, a thickness of each of the p layer and the n layer is preferably in the range of 1 to 50 nm, and most preferably in the range of 3 to 10 nm.

Examples of a raw material gas suitable for the deposition of the p layer and the n layer of the photovoltaic device, include a compound which contains silicon atoms and which can be gasified, a compound which contains germanium atoms and which can be gasified, a compound which contains carbon atoms and which can be gasified, and a mixed gas of these compounds.

Examples of the compounds which contain a silicon atom and which can be gasified, include SiH4, SiH₆, SiF₄, SiFH₃, SiF₂H₂, SiF₃H, Si₃H₈, SiD₄, SiHD₃, SiH₂D₂, SiH₃D, SiFD₃, SiF₂D₂, SiD₃H, and Si₂D₃H₃.

Examples of the compounds which contain a germanium atom and which can be gasified, include GeH₄, GeD₄, GeF₄, GeFH₃, GeF₂H₂, GeF₃H, GeHD₃, GeH₂D₂, GeH₃D, GeH₆, and GeD₆.

Examples of the compounds which contain a carbon atom and which can be gasified, include CH₄, CD₄, CₙH₂ₙ₊₂ (n is an integer), CₙH₂ₙ (n is an integer), C₂H₂, C₆H₆, CO₂, and CO.

Examples of the nitrogen-containing gases include N₂, NH₃, ND₃, NO, NO₂, and N₂O.

Examples of the oxygen-containing gases include O₂, CO, CO₂, NO, NO₂, N₂O, CH₃CH₂OH, and CH₃OH.

Examples of the materials to be introduced to a p layer or an n layer for controlling valence electrons include atoms of III group and V group of the periodic table.

Examples of the compound to be used effectively as a starting material for introducing a group III atom, specifically, for introducing a boron atom, include boron hydrides such as B₂H₆, B₄H₁₀, B₅H₉, B₅H₁₁, B₆H₁₀, B₆H₁₂, and B₆H₁₄; and boron halides such as BF₃ and BCl₃. Other examples include AlCl₃, GaCl₃, InCl₃, and TlCl₃. Of those, B₂H₆ and BF₃ are particularly preferred.

Examples of the compound to be used effectively as a starting material for introducing a V group atom, specifically, for introducing a phosphorus atom, include phosphorus hydrides such as PH₃ and P₂H₄; and phosphorus halides such as PH₄I, PF₃, PF₅, PCl₃, PCl₅, PBr₃, PBr₅, and PI₃. Other examples include AsH₃, AsF₃, AsCl₃, AsBr₃, AsF₅, SbH₃, SbF₃, SbF₅, SbCl₃, SbCl₅, BiH₃, BiCl₃, and BiBr₃. Of those, PH₃ and PF₃ are particularly preferred.

As for a method of depositing the p layer or the n layer suitable for the photovoltaic device, there is known the RF plasma CVD method, the VHF plasma CVD method, the microwave plasma CVD method, or the like. In particular, when the p layer or the n layer is deposited by utilizing the RF plasma CVD method, the capacitive coupling RF plasma CVD method is suitable for the deposition. When the p layer or the n layer is deposited by utilizing the RF plasma CVD method, it is given as the optimal conditions that in the deposition chamber, a substrate temperature is in the range of 100 to 350°C, an internal pressure is in the range of 13 to 6.7 × 10³ Pa (0.1 to 50 Torr), an RF electric power is in the range of 0.01 to 5.0 W/cm², and a deposition rate is in the range of 0.1 to 3 nm/sec.

In addition, any of the above-mentioned gasifiable compounds may be suitably diluted with a gas such as H₂, He, Ne, Ar, Xe, or Kr to be introduced into the deposition chamber.

In particular, in a case where the layer is deposited which comprises a microcrystalline semiconductor, a-Si:H or the like having less light absorption or a wide band gap, it is preferable that a raw material gas is diluted with a hydrogen gas 2 to 100 times, and a relatively high electric power is introduced as each of the RF and VHF electric powers. The range of 1 to 30 MHz is the suitable range in terms of a frequency, and in particular, the frequency range of 13.56 to 100 MHz is optimal.

In a case where the p layer or the n layer is deposited by utilizing the microwave plasma CVD method, a method in which a microwave is introduced through a waveguide into the deposition chamber via a dielectric window (made of alumina ceramics or the like) is suitable for the microwave plasma CVD system. In the case where the p layer or the n layer is deposited by utilizing the microwave plasma CVD method, though the deposition film forming method of the present invention is also a suitable deposition method, in this case, deposited films which can be applied to the photovoltaic device can be formed under the wider deposition conditions.

In the case where the p layer or the n layer is deposited by utilizing the microwave plasma CVD method, it is given as preferable conditions that in the deposition chamber, a substrate temperature is in the range of 100 to 400°C, an internal pressure is in the range of 67 to 4.0 × 10³ Pa (0.5 to 30 mTorr), a microwave electric power is in the range of 0.01 to 1 W/cm³, and a frequency of the microwave is in the range of 0.5 to 10 GHz.

In addition, any of the above-mentioned gasifiable compounds may be suitably diluted with a gas such as H₂, He, Ne, Ar, Xe, or Kr to be introduced into the deposition chamber.

In particular, in a case where a layer is deposited which comprises a microcrystalline semiconductor, a-SiC:H or the like having less light absorption or a wide band gap, it is preferable that a row material gas is diluted with a hydrogen gas 2 to 100 times, and a relatively high electric power is introduced as the electric power of the microwave.

### <Microcrystalline i Layer>

As a method suitable for deposition of the microcrystalline silicon of the stacked photovoltaic device of the present invention, there is given the RF plasma CVD method, the VHF plasma CVD method, the microwave plasma CVD method, or the like. In particular, a deposition rate of the microcrystalline silicon depends on a used electromagnetic wave, and hence in case of the same supplied energy, the deposition rate is further increased as the frequency becomes higher.

Examples of the raw material gas for supplying a silicon atom, which is suitable for microcrystalline silicon according to the present invention, include silane-based raw material gases such as SiH₄, Si₂H₆, SiF₄, SiHF₃, SiH₂F₂, SiH₃F, SiH₃Cl, SiH₂Cl₂, SiHCl₃, SiCl₄, SiD₄, SiHD₃, SiH₂D₂, SiH₃D, SiFD₃, SiF₂D₂, SiD₃H, and Si₂D₃H₃.

The raw material gas, for forming an excellent microcrystalline semiconductor, needs to be diluted with a hydrogen gas, and its dilution rate is preferably equal to or larger than 2 times. An especially preferable dilution rate is in the range of 5 to 100 times. In case of a small dilution rate, a microcrystal is not formed, but an amorphous is formed. On the other hand, in a case where the dilution rate is made too large, the deposition rate of the microcrystal becomes too low, and hence a practical problem arises. In addition, the raw material gas may also be diluted with a helium gas instead of using a hydrogen gas.

The substrate temperature for forming a microcrystal suitable for the present invention is in the range of 100 to 500°C. The substrate temperature exerts a large influence on the characteristics of microcrystalline silicon film, and especially is desirably controlled with accuracy so as to fall within the temperature range of 100 to 300°C.

As for a degree of vacuum within the chamber when depositing the microcrystal of the present invention, the range of 133 mPa to 6.7 × 10³ Pa (1 mTorr to 50 Torr) is given as the suitable range. In particular, in the case where the microcrystalline semiconductor is deposited by utilizing the microwave plasma CVD method, a preferable degree of vacuum is several hundreds mPa. Also, in case of the VHF plasma CVD method, equal to or higher than 13 Pa (100 mTorr) is preferable. In particular, a degree of vacuum is set as a high pressure to equal to or higher than 2.7 × 10² Pa (2 Torr) to thereby allow a film formation rate to be enhanced.

For the electric power supplied to the chamber when the microcrystalline semiconductor in the present invention is deposited, the range of 0.01 to 10 W/cm² is given as the suitable range. In addition, in view of a relationship between a flow rate of a raw material gas and a supplied electric power, a power limited area is suitable in which the deposition rate depends on the supplied electric power.

Moreover, for the deposition of the microcrystalline semiconductor in the present invention, a distance between the substrate (electrode) and the electrode for supply of an electric power is an important factor. The distance between the electrodes at which a microcrystalline semiconductor suitable for the present invention can be obtained is in the range of 5 to 50 mm, and especially preferably in the range of 5 to 15 mm.

With respect to a mean crystal grain diameter suitable for the microcrystalline semiconductor of the stacked photovoltaic device of the present invention, the range of 10 to 100 nm is given as the suitable range. In addition, as a ratio of amorphous contained in a microcrystalline semiconductor, the ratio of a peak concerned with an amorphous to a peak concerned with a crystal when viewed with Raman spectrum is desirably equal to or smaller than 70%.

If the mean crystal grain diameter is smaller than 10 nm, then a large amount of amorphous become present in grain boundaries to show light degradation. In addition, if a crystal grain diameter is small, then mobilities and lives of electrons and holes become short so that the characteristics as a semiconductor are deteriorated. On the other hand, if the mean crystal grain diameter is larger than 100 nm, then relaxation of grain boundaries is not sufficiently advanced. As a result, defects such as un-bonded hands and the like are generated in the grain boundaries, and these defects act as recombination centers for electrons and holes to deteriorate the characteristics of the microcrystalline semiconductor.

In addition, as for a shape of a microcrystal, a shape which is elongated along a direction of movement of electric charges is suitable. Also, a rate of hydrogen atoms or halogen atoms contained in a microcrystal in the present invention is desirably equal to or smaller than 30%.

In the photovoltaic device, the i layer is an important layer through which carriers are generated by application of light to be transported. An i layer slightly including a p layer or an n layer can be used as the i layer (discrimination in conductivity type between a p-type and an n-type depends on the distribution such as a tail state of intrinsic defects.

For the microcrystalline i layer of the stacked photovoltaic device of the present invention, a microcrystalline i layer is also suitable which contains therein silicon atoms and germanium atoms so as for a band gap to be smoothly changed in a direction of a thickness of an i layer so that a local minimum value of the band gap is deviated in a direction of an interface between a p layer and the i layer from a central position of the i layer, in addition to a semiconductor having a uniform band gap. Furthermore, a semiconductor an i layer of which is simultaneously doped with a valence electron control agent serving as donors and a valence electron control agent serving as acceptors is also suitable for the microcrystalline i layer.

In particular, a distribution form in which many hydrogen atoms and/or many halogen atoms are distributed on a side of each of the interface between the p layer and the i layer, and the interface between the n layer and the i layer is given as a preferable distribution form. Also, the range in which a content of hydrogen atoms and/or halogen atoms in the vicinity of each of the interfaces is 1.1 to 2 times as that in the bulk is given as a preferable range. Moreover, it is preferable that the content of hydrogen atoms and/or halogen atoms is changed in correspondence to a content of silicon atoms. A content of hydrogen atoms and/or halogen atoms in an area having a minimum content of silicon atoms is preferably in the range of 1 to 10 at%, which preferably corresponds to 0.3 to 0.8 times as large as the maximum content of hydrogen atoms and/or halogen atoms.

The content of hydrogen atoms and/or halogen atoms is changed in correspondence to a content of silicon atoms. That is to say, the content of hydrogen atoms and/or halogen atoms is low in an area having a narrow band gap in correspondence to a band gap.

The details of the mechanism are not clear. However, it is conceivable that in accordance with the deposition film forming method of the present invention, in the deposition of an alloy-based semiconductor containing therein silicon atoms and germanium atoms, a difference occurs between the electromagnetic wave acquired by the silicon atoms and the electromagnetic wave acquired by the germanium atoms due to a difference in ionization rate between the silicon atoms and the germanium atoms, and as a result, even if a content of hydrogen and/or a content of halogen is not ample in an alloy-based semiconductor, the relaxation is sufficiently advanced to allow an excellent alloy-based semiconductor layer to be deposited.

A thickness of the microcrystalline i layer largely depends on a structure of a photovoltaic device (e.g., a triple cell, a quadruple cell or the like). However, the range of 0.7 to 20.0 µm is given as the optimal range.

In the microcrystalline i layer containing therein silicon atoms formed in accordance with the deposition film forming method of the present invention, even if a deposition rate is increased up to equal to or higher than 5 nm/sec, only a subtle tail state is present on a side of a valence band, and a gradient of the tail state is equal to or smaller than 60 meV, and also a density of un-bonded hands due to electron spin resonance (ESR) is equal to or lower than 10¹⁷/cm³.

In addition, the design is preferably made so that a band gap of the microcrystalline i layer becomes wide in a direction of each of the interface between the p layer and the i layer, and the interface between the n layer and the i layer. By adopting such a design, it is possible to increase the photovoltaic voltage and the photoelectric current of the photovoltaic device, and also it is possible to prevent light degradation or the like when the photovoltaic device is used for a long period of time.

### <Amorphous i Layer>

In the present invention, while the first i layer is not especially limited in terms of a material, an amorphous silicon layer having a band gap of equal to or higher than 1.7 eV is desirably used for the first i layer. A wide band gap makes it possible that a high open voltage can be obtained and short wavelength components of solar light can be photoelectrically converted with high efficiency. In addition, an amorphous silicon carbide layer having a wider band gap may also be used. In addition, the densities of the photoelectric currents flowing through the elements can be further decreased as the number of stacked layers is further increased in a serial type multi-layer stacked structure. Hence, it becomes possible to greatly reduce the light degradation that is a disadvantage of an amorphous silicon layer. For this reason, for the first i layer, the large degree of freedom can be obtained with respect to the selection of a material, a band gap, and the like.

As a method suitable for deposition of the amorphous silicon of the stacked photovoltaic device of the present invention, there is given the RF plasma CVD method, the VHF plasma CVD method, the microwave plasma CVD method, or the like. In particular, a deposition rate of the amorphous silicon depends on a used electromagnetic wave, and hence in case of the same supplied energy, the deposition rate is further increased as the frequency becomes higher.

Examples of the raw material gas for supplying a silicon atom, which is suitable for amorphous silicon according to the present invention, include silane-based raw material gases such as SiH₄, Si₂H₆, SiF₄, SiHF₃, SiH₂F₂, SiH₃F, SiH₃Cl, SiH₂Cl₂, SiHCl₃, SiCl₄, SiD₄, SiHD₃, SiH₂D₂, SiH₃D, SiFD₃, SiF₂D₂, SiD₃H, and Si₂D₃H₃.

The raw material gas, for forming an excellent amorphous, needs to be diluted with a hydrogen gas, and its dilution rate is preferably equal to or larger than 2 times. An especially preferable dilution rate is in the range of 5 to 50 times. In addition, the raw material gas may also be diluted with a helium gas instead of using a hydrogen gas.

The substrate temperature suitable for forming an amorphous is in the range of 100 to 500°C. In a case where the deposition rate is especially increased, the substrate temperature is desirably set to a relatively high temperature.

As for a degree of vacuum within the chamber when depositing the amorphous of the present invention, the range of 133 mPa to 6.7 × 10³ Pa (1 mTorr to 50 Torr) is given as the suitable range. In particular, in the case where the amorphous semiconductor is deposited by utilizing the microwave plasma CVD method, a preferable degree of vacuum is several hundreds mPa to 133 Pa (several mTorr to 1 Torr). Also, in case of the VHF plasma CVD method, the degree of vacuum is preferably in the range of 13 Pa to 4.0 × 10³ Pa (0.1 to 30 Torr).

For the electric power supplied to the chamber when the amorphous semiconductor in the present invention is deposited, the range of 0.01 to 5 W/cm² is given as the suitable range. In addition, in view of a relationship between a flow rate of a raw material gas and a supplied electric power, a power limited area is suitable in which the deposition rate depends on the supplied electric power. In a case where the deposition rate of the amorphous semiconductor is increased, the bias voltage is preferably controlled so that ions collide with the substrate.

Also, a rate of hydrogen atoms or halogen atoms contained in the amorphous in the present invention is desirably in the range of 5 to 30%.

In the photovoltaic device, the i layer is an important layer through which carriers are generated by application of light to be transported. An i layer slightly including a p layer or an n layer can be used as the i layer (discrimination in conductivity type between a p-type and an n-type depends on the distribution such as a tail state of intrinsic defects.

For the amorphous i layer of the stacked photovoltaic device of the present invention, an amorphous i layer is also suitable which contains therein silicon atoms and hydrogen atoms at a content rate so varying in a direction of a thickness of an i layer for a band gap as to be smoothly changed so that a local minimum value of the band gap is deviated in a direction of an interface between a p layer and the i layer from a central position of the i layer, in addition to a semiconductor having a uniform band gap. Furthermore, a semiconductor an i layer of which is simultaneously doped with a valence electron control agent serving as donors and a valence electron control agent serving as acceptors is also suitable for the microcrystalline i layer.

In particular, a distribution form in which many hydrogen atoms and/or many halogen atoms are distributed on a side of each of the interface between the p layer and the i layer, and the interface between the n layer and the i layer is given as a preferable distribution form. Also, the range in which a content of hydrogen atoms and/or halogen atoms in the vicinity of each of the interfaces is 1.1 to 2 times as that in the bulk is given as a preferable range. Moreover, it is preferable that the content of hydrogen atoms and/or halogen atoms is changed in correspondence to a content of silicon atoms. A content of hydrogen atoms and/or halogen atoms in an area having a minimum content of silicon atoms is preferably in the range of 1 to 10 at%, which preferably corresponds to 0.3 to 0.8 times as large as the maximum content of hydrogen atoms and/or halogen atoms. In a case where the semiconductor layer contains both hydrogen atoms and halogen atoms, the content of halogen atoms is preferably equal to or smaller than 1/10 of that of hydrogen atoms.

The content of hydrogen atoms and/or halogen atoms is changed in correspondence to a content of silicon atoms. That is to say, the content of hydrogen atoms and/or halogen atoms is low in an area having a narrow band gap in correspondence to a band gap.

A layer thickness of the amorphous i layer largely depends on a structure of a photovoltaic device (e.g., a single cell, a tandem cell, a triple cell, or the like) and a band gap of the i layer. However, the range of 0.05 to 1 µm is given as the optimal range.

In the amorphous i layer containing therein silicon atoms or germanium atoms and formed in accordance with the deposition film forming method of the present invention, even if a deposition rate is increased up to equal to or higher than 5 nm/sec, only a subtle tail state is present on a side of a valence band, and a gradient of the tail state is equal to or smaller than 60 meV, and also a density of un-bonded hands due to electron spin resonance (ESR) is equal to or lower than 5 × 10¹⁷/cm³.

In addition, the design is preferably made so that a band gap of the amorphous i layer becomes wide in a direction of each of the interface between the p layer and the i layer, and the interface between the n layer and the i layer. By adopting such a design, it is possible to increase the photovoltaic voltage and the photoelectric current of the photovoltaic device, and also it is possible to prevent light degradation or the like when the photovoltaic device is used for a long period of time.

### <Transparent Electrode>

A transparent electrode made of indium oxide, indium-tin oxide, or the like is suitable for the transparent electrode of the present invention.

As for a method including depositing a layer of the transparent electrode, the sputtering method and the vacuum evaporation method are given as the optical deposition method. When a transparent electrode made of indium oxide is deposited on the substrate using a D.C. magnetron sputtering system, metal indium (In), indium oxide (In₂O₃) or the like is used for a target.

In addition, when a transparent electrode made of indium-tin oxide is deposited on the substrate, for a target, metal tin, metal indium, an alloy of metal tin and metal indium, tin oxide, indium oxide, indium-tin oxide, and the like are suitably combined with each other to be used.

When the deposition is carried out by utilizing the sputtering method, a substrate temperature is an important factor, and the range of 25 to 600°C is given as the preferable range. In addition, as for gas used for the sputtering, an inactive gas such as argon gas (Ar), neon gas (Ne), xenon gas (Xe), or helium gas (He) is given, and in particular, an Ar gas is optimal. Also, an oxygen gas (O₂) is preferably added to the above-mentioned inactive gas if necessary. In particular, when metal is used as the target, it is essential to add the oxygen gas (O₂).

Moreover, for effectively carrying out the sputtering using the above-mentioned inactive gas, a pressure in a discharge space preferably falls within the range of 13 mPa to 6.7 Pa (0.1 to 50 mTorr). In addition, a D.C. power supply or an RF power supply is suitable for a power supply for the sputtering, and the range of 10 to 1,000 W is suitable for an electric power during the sputtering.

The deposition rate of the transparent electrode depends on the pressure within the discharge space and the discharge electric power, and the optimal deposition rate is in the range of 0.01 to 10 nm/sec.

The transparent electrode is preferably deposited under such conditions as to meet the conditions required for an antireflection film, and more specifically, for its layer thickness, the range of 50 to 300 nm is given as the preferable range. As for an evaporation source suitable for depositing the transparent electrode by utilizing the vacuum evaporation method, metal tin, metal indium, an indium-tin alloy, or the like is given.

Also, the temperature range of 25 to 600°C is suitable for the substrate temperature when depositing the transparent electrode.

Moreover, when depositing the transparent electrode, it is required that after the pressure in the deposition chamber is reduced to equal to or lower than 1.3 × 10⁻¹⁴ Pa (10⁻⁶ Torr), an oxygen gas (O₂) is introduced so as to meet a degree of vacuum in the range of 6.7 × 10⁻³ to 1.2 × 10⁻¹ Pa (5 × 10⁻⁵ to 9 × 10⁻⁴ Torr). The oxygen is introduced so as to meet the degree of vacuum in that range, whereby metal gasified from the evaporation source reacts the oxygen in the vapor phase to deposit a layer of an excellent transparent electrode.

In addition, an RF electric power may be introduced at the above-mentioned degree of vacuum to generate the plasma to thereby evaporate the evaporation source in the plasma ambient atmosphere.

The deposition rate of the transparent electrode according to the above-mentioned conditions is preferably in the range of 0.01 to 10 nm/sec. This reason is that if the deposition rate is lower than 0.01 nm/sec, then the productivity is lowered, while if the deposition rate is higher than 10 nm/sec, then the transparent electrode becomes a rough film to reduce a transmittance, an electric conductivity, and adhesion.

### <Collector Electrode>

In the present invention, when a resistivity of the transparent electrode can not be sufficiently reduced, the collector electrode is formed on a part of the transparent electrode if necessary, and serves to reduce the resistivity of the electrode to reduce a series resistance of the photovoltaic device.

As for a material of the collector electrode, there is given metal such as gold, silver, copper, aluminium, nickel, iron, chrome, molybdenum, tungsten, titanium, cobalt, tantalum, niobium, or zirconium, or an alloy such as stainless steel, or electroconductive paste using powder metal, or the like. Then, as for a shape, the collector electrode is formed into a comb-like shape so as not to block off the incident light to the semiconductor layer as much as possible.

In addition, a ratio of an area occupied by the collector electrode to the whole area of the photovoltaic device is preferably equal to or smaller than 15%, more preferably equal to or smaller than 10%, and optimally equal to or smaller than 5%.

A mask is used for formation of a pattern of the collector electrode, and as for a formation method, there is given the vacuum evaporation method, the sputtering method, the metal plating method, the printing method, or the like.

Note that, in a case where a photovoltaic device having a desired output voltage and a desired output current is manufactured using the stacked photovoltaic device of the present invention, the stacked photovoltaic devices of the present invention are connected in series or in parallel with one another, protection layers are formed on a surface and a rear face, respectively, electrodes for deriving an output signal from the device, and the like are mounted. In addition, when the photovoltaic devices of the present invention are connected in series with one another, a diode for preventing a back flow may be incorporated in some cases.

Examples of the present invention will hereinafter be described in detail with reference to the accompanying drawings. However, the present invention is not intended to be limited to these examples.

### (Example 1 and Comparative Example 1)

The layers of the constituent elements of the stacked photovoltaic device of this example were deposited using the deposition film forming system shown in FIG. 5. The common deposition conditions used in Example 1 and Comparative Example 1 are shown in Table 3. There were selected the manufacturing conditions such that the i-type semiconductor layer of the top element was made of amorphous silicon, and each of the i-type semiconductor layers of the middle element and the bottom element was made of microcrystalline silicon. In Example 1, there was manufactured the photovoltaic device in which a layer thickness of the i-type semiconductor layer of the middle element was set to 2.0 µm to make a triple element a middle control element, and Voc/t of the middle element was larger than that of the bottom element. In addition, in Comparative Example 1, there was manufactured the photovoltaic device in which while a layer thickness of the middle element was increased up to 2.5 µm to make a triple element a bottom control element, a value of Voc/t of the middle element was still larger than that of the bottom element.

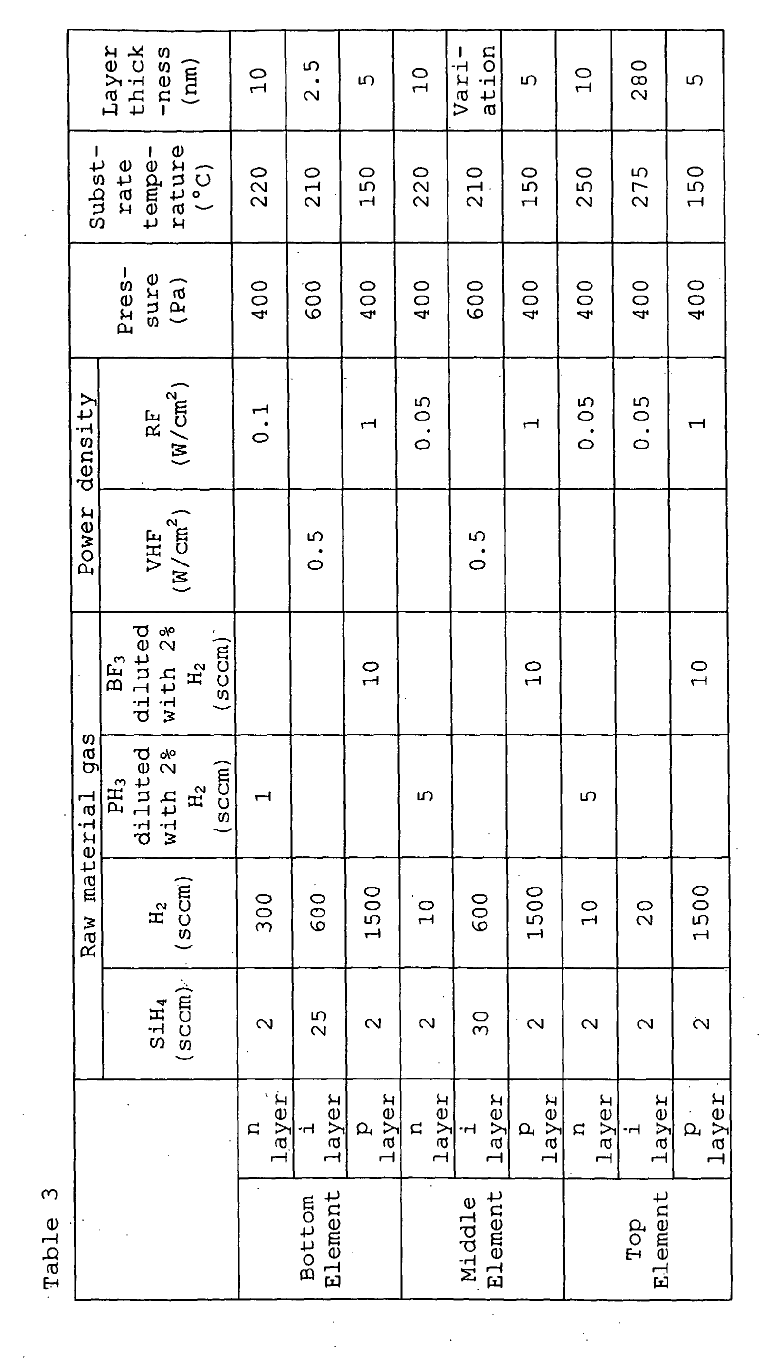

In Table 4, there are shown a value of Voc when each of the middle element and the bottom element at that time was manufactured in the form of a single element, the results of measuring a layer thickness of the i-type semiconductor layer by utilizing both the cross section SEM observation method and the capacitance measurement method, Voc/t, a short-circuit photoelectric current density of each of the elements, an initial photoelectric conversion efficiency, and a photoelectric conversion efficiency after application of light (1SUN, at 50°C for 1,000 hours). The short-circuit photoelectric current densities of the top elements were 10.5 mA in both Example 1 and Comparative Example 1.

From Table 4, it is understood that though the initial photoelectric conversion efficiency of Example 1 is equal to that of Comparative Example 1, the photoelectric conversion efficiency after degradation is enhanced in a sample of Example 1. In Example 1, the middle control is provided and Voc/t of the middle element is large, while in Comparative Example 1, the bottom control is provided and Voc/t of the middle element is large. Consequently, it is confirmed that Voc/t of the control element as the constitution of the present invention is made large to greatly enhance the photoelectric conversion efficiency after degradation.

In addition, a layer thickness measured by utilizing the cross section SEM observation method and a layer thickness measured by utilizing the capacitance measurement method show the same value. Hence, the diffusion of the doping elements or the like into the i-type semiconductor layer is at an ignorable level, and this value of the layer thickness is adapted for calculation of Voc/t as it is.

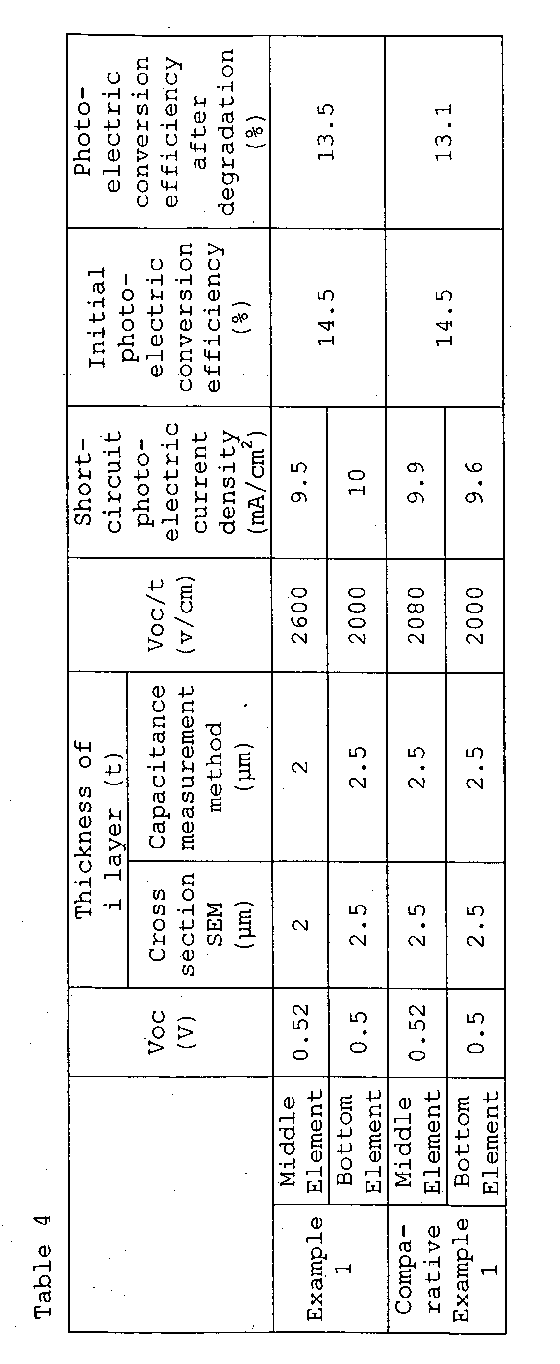

### (Example 2 and Comparative Example 2)

In this example, a layer thickness and film formation conditions of the reflection enhancing film were adjusted, whereby the texture degree of a surface of the reflection enhancing film was greatly increased as compared with the reflection enhancing film used in Example 1. As a result, the number of photons absorbed in the bottom element can be increased to decrease a layer thickness of the i layer of the bottom element. Then, in Example 2, the semiconductor layers were formed under the conditions shown in Table 3 except that the i layer of the bottom element was thinned to 20 µm. Similarly to Example 1, the i-type semiconductor layer of the top element was made of amorphous silicon, and each of the i-type semiconductor layers of the middle element and the bottom element was made of microcrystalline silicon. In Example 2, there was manufactured the photovoltaic device such that a layer thickness of the i layer of the middle element was set to 2.5 µm, whereby the triple device is made the bottom control element, and Voc/t of the bottom element was larger than that of the middle element. In addition, in Comparative Example 2, there was manufactured the photovoltaic device such that though a layer thickness of the middle element was decreased to 2.2 µm to thereby make a triple element a middle control element, a value of Voc/t of the bottom element was still larger than that of the middle element.

In Table 5, there are shown a value of Voc when each of the middle element and the bottom element at that time was manufactured in the form of a single element, the results of measuring a layer thickness of the i-type semiconductor layer by utilizing both the cross section SEM observation method and the capacitance measurement method, Voc/t, a short-circuit photoelectric current density of each of the elements, an initial photoelectric conversion efficiency, and a photoelectric conversion efficiency after application of light (1SUN, at 50°C for 1,000 hours). The short-circuit photoelectric current densities of the top elements were 10.5 mA/cm² in both Example 2 and Comparative Example 2.

From Table 5, it is understood that though the initial photoelectric conversion efficiency of Example 2 is equal to that of Comparative Example 2, the photoelectric conversion efficiency after degradation is enhanced in a sample of Example 2. In Example 2, the bottom control is provided and Voc/t of the bottom element is large, while in Comparative Example 2, the middle control is provided and Voc/t of the bottom element is large. Consequently, in this example as well, it is confirmed that Voc/t of the control element as the constitution of the present invention is made large to greatly enhance the photoelectric conversion efficiency after degradation.

In addition, a layer thickness measured by utilizing the cross section SEM observation method and a layer thickness measured by utilizing the capacitance measurement method show the same value. Hence, the diffusion of the doping elements or the like into the i-type semiconductor layer is at an ignorable level, and this value of the layer thickness is adapted for calculation of Voc/t as it is.

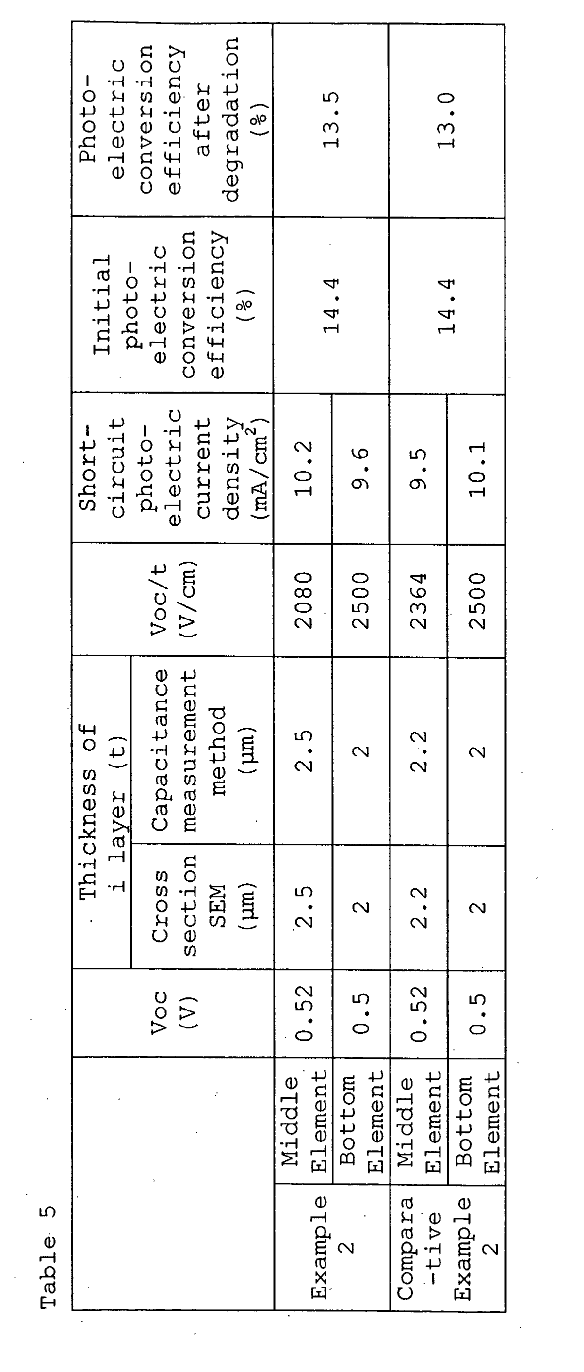

### (Example 3, and Comparative Examples 3-1 and 3-2)

In Example 3, the semiconductor layers were formed under the same conditions as those of Example 1 shown in Table 3 except that as the conditions of formation of the n-type semiconductor layer of the bottom element, a flow rate of PH₃ as an n-type doping gas was made 20 times as high as that in Example 1 in order to form the n-type semiconductor layer of the bottom element. While enhancement of Voc was obtained by increasing the flow rate of PH₃, the short-circuit photoelectric current density of the bottom element was decreased to provide a bottom control element, and the same photoelectric conversion efficiency was obtained. This is conceived to be because the diffusion of P into the i-type semiconductor layer exerts an influence on the results. When the measurement was actually carried out by utilizing SIMS, it became clear that the concentration of P in the i-type semiconductor layer of the bottom element was higher than that of P in the i-type semiconductor layer of the bottom element of Example 1 by a half digit on the average. In addition, similarly to Example 1 and Example 2, the concentration of P in the i layer of the middle element in Example 3 and Comparative Examples 3-1 and 3-2 was at an ignorable level. Hence, the i-type semiconductor layer of the top element was made of amorphous silicon, and the i-type semiconductor layer of each of the middle element and the bottom element was made of microcrystalline silicon. In Comparative Example 3-1, there was manufactured the photovoltaic device such that the formation time of the i layer of the bottom element was increased by 20% to increase the short-circuit photoelectric current of the bottom element to change the control over to the middle control. On the other hand, in Comparative Example 3-2, there was manufactured the photovoltaic device such that the formation time of the i layer of the middle element was decreased by 10% as compared with Example 3 to change the control over to the middle control.

In Table 6, there are shown a value of Voc when each of the middle element and the bottom element at that time was manufactured in the form of a single element, the results of measuring a layer thickness of the i-type semiconductor layer by utilizing both the cross section SEM observation method and the capacitance measurement method, Voc/t, a short-circuit photoelectric current density of each of the elements, an initial photoelectric conversion efficiency, and a photoelectric conversion efficiency after application of light (1SUN, at 50°C for 1,000 hours). The short-circuit photoelectric current densities of all the top elements were 10.5 mA/cm².

From Table 6, it is understood that though the initial photoelectric conversion efficiency of Example 3 is equal to that of Comparative Example 3-1 or Comparative Example 3-2, the photoelectric conversion efficiency after degradation is enhanced in a sample of Example 3. In Example 3, the bottom control is provided and Voc/t of the bottom element is large, while in Comparative Example 3-1 and Comparative Example 3-2, the middle control is provided and Voc/t of the bottom element is large. Consequently, in this example as well, it is confirmed that Voc/t of the control element as the constitution of the present invention is made large to greatly enhance the photoelectric conversion efficiency after degradation.

In addition, in Example 3, Comparative Example 3-1, and Comparative Example 3-2, it was made clear that a layer thickness measured with the capacitance measurement method was smaller than that measured with the cross section SEM observation method due to the diffusion of P into the i layer of the bottom element. Then, a layer thickness measured with the capacitance measurement method was adopted for calculation of Voc/t.

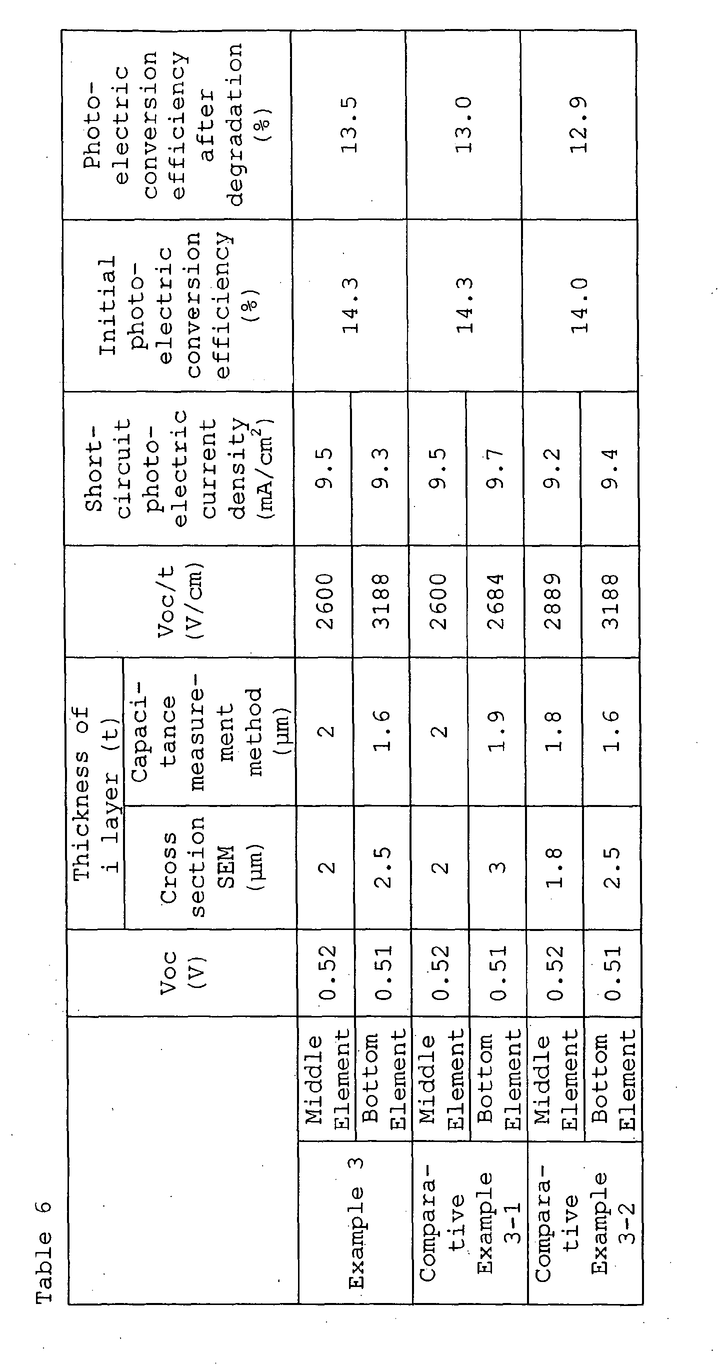

### (Example 4)

In Example 4, there was manufactured a triple element which was identical to that of Example 1 except that a layer thickness of the i layer of the top element was decreased in Example 1 to reduce the short-circuit photoelectric current density of the top element to 9.8 mA/cm². Under this condition, Example 4 was compared with Example 1. Table 7 shows a value of Voc, the results of measuring a layer thickness of the i-type semiconductor layer by utilizing both the cross section SEM observation method and the capacitance measurement method, Voc/t, a density of a short-circuit photoelectric current of each of the elements, an initial photoelectric conversion efficiency, and a photoelectric conversion efficiency after application of light (1SUN, at 50°C for 1,000 hours) when each of the top element, the middle element, and the bottom element at that time was manufactured in the form of a single element.

From Table 7, it is understood that though the initial photoelectric current efficiency in Example 4 is equal to that in Example 1, the photoelectric current efficiency after degradation in Example 4 is slightly reduced as compared with that in Example 1. It is conceived that this is because since the short-circuit photoelectric current density of the top element having the i layer made of amorphous silicon is lower than that of the bottom element having the i layer made of microcrystalline silicon, the light degradation of the top element becomes remarkable. As a result, it is confirmed that the short-circuit photoelectric current density of the pin element having the i-type semiconductor layer made of amorphous silicon is made larger than that of the pin element having the i-type semiconductor layer made of microcrystalline silicon to thereby allow the photovoltaic device having a higher efficiency to be formed.

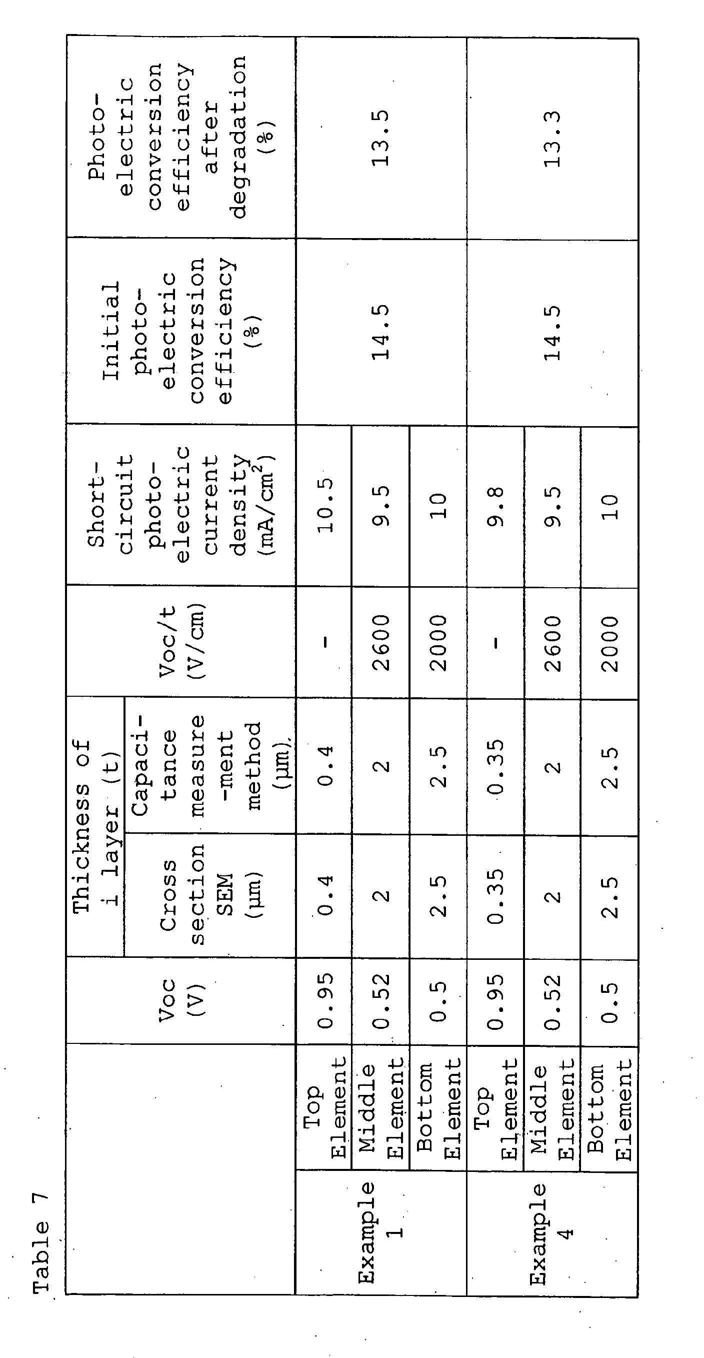

As set forth hereinabove, according to the present invention, in the stacked photovoltaic device having a plurality of i-type semiconductor layers each made of microcrystalline silicon, it is possible to show the excellent effects such as the photovoltaic conversion efficiency is high, and the photoelectric conversion efficiency after application of light for a long period of time can be maintained at a high level.

Provided is a stacked photovoltaic device characterized in that: a first i-type semiconductor layer comprises amorphous silicon hydride, and second and subsequent i-type semiconductor layers comprise amorphous silicon hydride or microcrystalline silicon, the i-type semiconductor layers being stacked in order from a light incidence side; and when an open circuit voltage is assigned Voc in the case where a pin photoelectric single element is manufactured using a pin element having the i-type semiconductor layer made of microcrystalline silicon of pin elements having the second and subsequent i-type semiconductor layers, respectively, and a layer thickness of the i-type semiconductor layer concerned is assigned t, a short-circuit photoelectric current density of the stacked photovoltaic device is controlled by the pin element including the i-type semiconductor layer having the largest value of Voc/t.

## Claims

1. A stacked photovoltaic device comprising a plurality of photovoltaic devices each having a pin junction including a p-type semiconductor, an i-type semiconductor, and an n-type semiconductor each made of a non-single crystal having an element belonging to the IV group as a main component and which are stacked on a substrate,
wherein a first i-type semiconductor layer comprises amorphous silicon hydride, and second and subsequent i-type semiconductor layers comprise amorphous silicon hydride or microcrystalline silicon, the i-type semiconductor layers being stacked in order from a light incidence side, and when an open circuit voltage is assigned Voc in the case where a pin photoelectric single element is manufactured using a pin element having the i-type semiconductor layer made of microcrystalline silicon of pin elements having the second and subsequent i-type semiconductor layers, respectively; and a layer thickness of the i-type semiconductor layer concerned is assigned t, a short-circuit photoelectric current density of the stacked photovoltaic device is controlled by the pin element including the i-type semiconductor layer having the largest value of Voc/t.

2. The stacked photovoltaic device according to claim 1, wherein when solar light of AM1.5 is applied to the stacked photovoltaic device under conditions of 1SUN and at 25°C, a sum of the short-circuit photoelectric current densities obtained from the individual layers is equal to or larger than 27 mA/cm².

3. The stacked photovoltaic device according to claim 1, wherein in the photovoltaic devices, the short-circuit photoelectric current density of the pin element having the i-type semiconductor layer made of amorphous silicon hydride is larger than that of the pin element having the i-type semiconductor layer made of microcrystalline silicon.
